# EUROPEAN PATENT APPLICATION

(11) **EP 4 818 718 A1**
(43) Date of publication of application: **07.10.2026**
(21) Application number: 24897523.7
(22) Date of filing: 26.11.2024
(51) Int. Cl.: G01R 31/3835, G01R 31/00, H01M 10/04, H01M 10/052, H01M 10/0585, H01M 10/0587

(54) **SECONDARY BATTERY TESTING METHOD**

(30) Priority: 30.11.2023 JP 2023202426
(71) Applicant: Panasonic Intellectual Property Management Co., Ltd., Kadoma-shi, Osaka 571-0057 (JP)
(72) Inventor: ITO, Katsuya, Osaka 571-0057 (JP); IIDA, Yuki, Osaka 571-0057 (JP); IKAWA, Hideki, Osaka 571-0057 (JP); KOUZAKI, Hiroki, Osaka 571-0057 (JP); OOTUKA, Kenji, Osaka 571-0057 (JP); INAI, Hiroaki, Osaka 571-0057 (JP); HAYAKUMO, Tomohiko, Osaka 571-0057 (JP); MAEOKA, Yuuji, Osaka 571-0057 (JP)
(74) Representative: Eisenführ Speiser
(86) International application number: PCT/JP2024/041754
(87) International publication number: WO 2025/115838

(57) **Abstract**

This secondary battery testing method includes a charging step (step S102) for charging a secondary battery to a prescribed charging state by constant voltage charging or constant voltage/constant current charging, an aging step (step S106) for aging the secondary battery charged in the charging step, voltage measuring steps (step S104 and step S108) for measuring the voltage of the secondary battery before and after aging, and a sorting step (step S110) for sorting the secondary battery on the basis of the voltages of the secondary battery measured in the voltage measuring steps, the testing method being characterized in that the prescribed charging state is set in a state of charge (SOC) region in which the slope of the tangent to an SOC-OCV curve indicating a relationship between the state of charge and the open circuit voltage (OCV) of the secondary battery is greater than 0.02.

## Description

### TECHNICAL FIELD

The present disclosure relates to a secondary battery testing method.

### BACKGROUND

A secondary battery such as a lithium ion secondary battery is produced, for example, by housing an electrode assembly in which a positive electrode and a negative electrode are wound or laminated with a separator interposed therebetween in a battery case, injecting an electrolytic solution, and performing caulking sealing or laser sealing.

As a testing method for selecting defective batteries mixed in the secondary batteries thus produced, for example, there is a method for performing aging in which the secondary batteries charged and discharged under predetermined conditions are left for a predetermined time, measuring electrical characteristics such as an open circuit voltage, a closed circuit voltage, and an internal resistance of the secondary batteries, and selecting the secondary batteries based on the electrical characteristics. For example, Patent Literatures 1 to 4 disclose a testing method for selecting a secondary battery by measuring the voltage of the secondary battery after aging.

### CITATION LIST

### PATENT LITERATURES

Patent Literature 1: JP 2014-17056 A
Patent Literature 2: JP 2004-288515 A
Patent Literature 3: JP 2005-158643 A
Patent Literature 4: JP 2001-228224 A

### SUMMARY

By the way, a testing method for measuring the voltage of a secondary battery and selecting a defective battery has a problem that the aging period of the secondary battery required to maintain the voltage measurement accuracy of the secondary battery is long. If the aging period is long, a testing period for selecting the defective battery is long, so that inventory under testing is held for a long period of time, which is not preferable.

Therefore, an object of the present disclosure is to provide a secondary battery testing method capable of shortening the testing period of the secondary battery.

A secondary battery testing method according to an aspect of the present disclosure includes: a charging step of constant-voltage charging or constant-voltage/constant-current charging a secondary battery to a predetermined state of charge; an aging step of aging the secondary battery charged in the charging step; a voltage measuring step of measuring a voltage of the secondary battery after at least the aging step; and a selecting step of selecting the secondary battery based on the voltage of the secondary battery measured in the voltage measuring step. The predetermined state of charge is set in a state of charge region where a gradient of a tangent of an SOC-OCV curve indicating a relationship between a state of charge (SOC) of the secondary battery and an open circuit voltage (OCV) is greater than 0.02.

According to one aspect of the present disclosure, it is possible to provide a secondary battery testing method capable of shortening the testing period of the secondary battery.

### BRIEF DESCRIPTION OF DRAWINGS

FIG. 1 is a flowchart of a secondary battery testing method as an example of an embodiment.
FIG. 2 is a diagram showing an example of the SOC-OCV curve of a lithium ion secondary battery.
FIG. 3 is a flowchart of a secondary battery testing method as another example of the embodiment.

### DESCRIPTION OF EMBODIMENTS

Hereinafter, an example of a secondary battery testing method according to the present disclosure will be described.

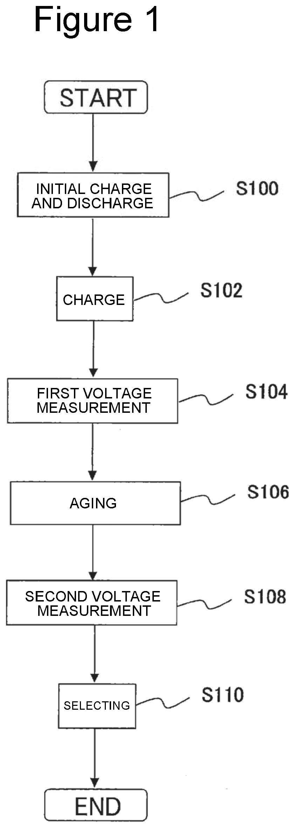

FIG. 1 is a flowchart of a secondary battery testing method as an example of an embodiment. Hereinafter, a lithium ion secondary battery will be described as a testing target, but the secondary battery as the testing target may be a secondary battery other than a lithium ion secondary battery such as an alkaline secondary battery. The number of secondary batteries to be tested at a time is not particularly limited, but is preferably, for example, greater than or equal to 100 and less than or equal to 200 in consideration of a testing time.

The secondary battery testing method shown in FIG. 1 includes an initial charging and discharging step (step S100), a charging step (step S102), a first voltage measuring step (step S104), an aging step (step S106), a second voltage measuring step (step S108), and a selecting step (step S110). Each of the steps will be described below.

### (Initial Charging and Discharging Step)

In the initial charging and discharging step (step S100), the lithium ion secondary battery is initially charged and discharged. The initial charge and discharge is first initial charge and discharge performed after the assembly of the secondary battery. Although the initial charge and discharge is not an essential configuration in the testing method of the present embodiment, it is preferable to perform the initial charge and discharge from the viewpoint of further improving the voltage measurement accuracy of the secondary battery performed thereafter. In particular, in the lithium ion secondary battery, it is preferable to perform the initial charge and discharge.

In the initial charge and discharge, it is preferable to charge the lithium ion secondary battery until the state of charge (SOC) reaches 100%, and discharge the lithium ion secondary battery until the state of charge reaches 0%. Charge in the initial charge and discharge may be charge in which the state of charge is less than 100%. Discharge in the initial charge and discharge may not be performed until the state of charge reaches 0%, but discharge is preferably performed at least until the state of charge reaches 5% or less, more preferably until the state of charge reaches 1% or less, and still more preferably until the state of charge reaches 0%, from the viewpoint of enhancing the voltage measurement accuracy of the secondary battery performed thereafter.

### (Charging Step)

Next, the process proceeds to the charging step (step S102), and the lithium ion secondary battery is constant-voltage charged or constant-voltage/constant-current charged to a predetermined state of charge. When the charging step is performed without performing the initial charge and discharge, the state of charge of the secondary battery is checked, and if the state of charge is high, the secondary battery is preferably discharged until the state of charge of the secondary battery reaches 5% or less, more preferably discharged until the state of charge of the secondary battery reaches 1% or less, and more preferably discharged until the state of charge of the secondary battery reaches 0%, before starting the charging step.

The predetermined state of charge is a state of charge region where the gradient of the tangent of an SOC-OCV curve indicating the relationship between the state of charge (SOC) and open circuit voltage (OCV) of the secondary battery is greater than 0.02. The state of charge region where the gradient of the tangent of the SOC-OCV curve is greater than 0.02 is seen in a low state of charge region, and is seen at least in a region in which the state of charge of the secondary battery is 20% or less.

The SOC-OCV curve of the lithium ion secondary battery can be obtained using a non-defective lithium ion secondary battery in which a minute internal short circuit does not occur. Specifically, the SOC-OCV curve of the lithium ion secondary battery can be obtained by measuring a discharge capacity integrated value at each time point while the secondary battery is discharged from a full state of charge (SOC=100%) to a full state of discharge (SOC=0%) and the open circuit voltage of the secondary battery after the secondary battery is stopped. The discharge capacity integrated value from the full state of charge at each time point during the discharge of the lithium ion secondary battery is Q (j) (j=1, 2,...), the open circuit voltage when the discharge capacity integrated value is Q (j) is OCV (j), and the discharge capacity from the full state of charge to the full state of discharge of the lithium ion secondary battery is Qmax. The SOC (j) at each time point during discharge is SOC(j)=(Qmax-Qb (j))/Qmax×100. The SOC-OCV curve is obtained based on the plot data of the SOC (j) and the open circuit voltage OCV (j) at each time point. The secondary battery in creating the SOC-OCV curve is charged and discharged by, for example, constant-current (0.5 C, 4.2 V cut)/constant-voltage (4.2 V, 0.02 C cut) charging until the SOC reaches 100%, then pausing for 10 minutes, and then repeatedly performing constant current discharge at 0.002 C for a predetermined time and pausing until the discharge voltage reaches 2.75 V.

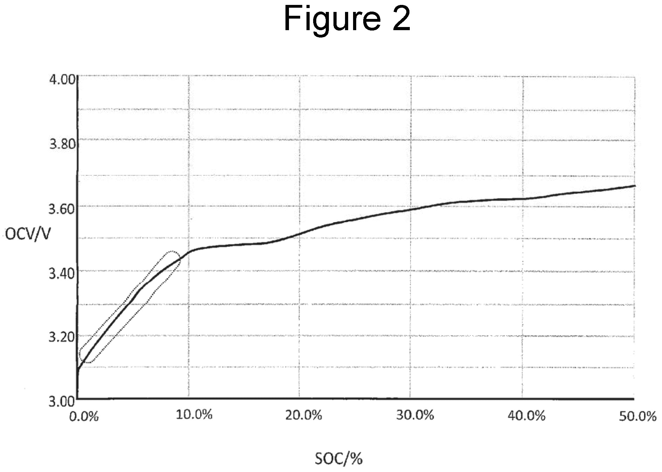

FIG. 2 is a diagram showing an example of the SOC-OCV curve of a lithium ion secondary battery. As shown in the SOC-OCV curve of the lithium ion secondary battery in FIG. 2, in a region where the state of charge of the secondary battery is low, the gradient of the tangent of the SOC-OCV curve (d (OCV)/d (SOC)) is large, and the gradient of the tangent of the SOC-OCV curve (d (OCV)/d (SOC)) decreases as the state of charge of the secondary battery increases. In the SOC-OCV curve of FIG. 2, the inside of a broken-line frame is a region where d (OCV)/d (SOC) is greater than 0.02, and when the state of charge is higher than the broken-line frame, d (OCV)/d (SOC) is smaller than 0.02. For example, when the SOC-OCV curve shown in FIG. 2 is used, the state of charge to be charged in step S102 is set within a range of 0.5% to 9% of the state of charge, and the lithium ion secondary battery is constant-voltage charged or constant-voltage/constant-current charged to the set state of charge.

The condition for the constant-voltage charge in step S102 is not particularly limited, but the lithium ion secondary battery is preferably charged at a voltage of greater than or equal to 3.1 V and less than or equal to 3.5 V. The constant-voltage/constant-current charge in step S102 is a method for performing the constant current charge after the constant-voltage charge. The condition of the constant-voltage charge in the constant-voltage/constant-current charge in step S102 is not particularly limited, but the lithium ion secondary battery is preferably charged at a voltage of greater than or equal to 2.9 V and less than or equal to 3.3 V, and the condition of the constant-current charge is not particularly limited, but for example, the lithium ion secondary battery is preferably charged at a constant current of greater than or equal to 0.2 C and less than or equal to 1.0 C.

By performing such constant-voltage charge or constant-voltage/constant-current charge, the SOC variation of each of a plurality of secondary batteries is eliminated when the secondary batteries are tested, and thus, even if the aging period when the voltage of the secondary battery is measured in the subsequent voltage measuring step is short, the voltage measurement accuracy of each secondary battery can be maintained. As a result, defective batteries can be selected in a shorter period of time. In step S102, the charging time is shortened by starting the charge of the lithium ion secondary battery from the constant-voltage charge, so that the testing period is further shortened.

### (Voltage Measuring Step: First Voltage Measuring Step, Second Voltage Measuring Step, and Aging Step)

Next, the process proceeds to the first voltage measuring step (step S104), and a voltage V1 of the lithium ion secondary battery before the aging step (step S106) is measured. In the aging step (step S106), the lithium secondary battery is left in an open circuit state for a predetermined time. The process proceeds to the second voltage measuring step (step S108), and a voltage V2 of the lithium ion secondary battery after the aging step (step S106) is measured.

An aging temperature in the aging step (step S106) is not particularly limited, but is, for example, preferably in the range of 15°C to 60°C, and more preferably in the range of 20°C to 40°C, from the viewpoint of stabilizing battery characteristics and the like.

An aging period in the aging step (step S106) is appropriately determined based on the specifications of the secondary battery to be tested. As described above, the SOC variation of each secondary battery is eliminated through the charging step (step S102), so that the aging period can be shortened.

### (Selecting Step)

In the selecting step (step S110), a voltage difference ΔV between the voltage V1 measured in the first voltage measuring step (step S104) and the voltage V2 measured in the second voltage measuring step (step S108) is obtained, and the lithium ion secondary battery is selected based on the voltage difference ΔV. In the selecting, for example, when the voltage difference ΔV falls within the range of the selection criteria, the lithium ion secondary battery is determined as a non-defective product, and when the voltage difference ΔV falls outside the range of the selection criteria, the lithium ion secondary battery is determined as a defective product. Examples of the selection criteria include ΔVA which is an average value of the voltage differences ΔV of the lithium ion secondary batteries and ΔVA±3σ obtained by calculating the standard deviation σ. When the voltage difference ΔV of the lithium ion secondary battery falls within the range of ΔVA±3σ, the lithium ion secondary battery is determined as a non-defective product, and when the voltage difference ΔV of the lithium ion secondary battery falls outside the range of ΔVA±3σ, the lithium ion secondary battery is determined as a defective product.

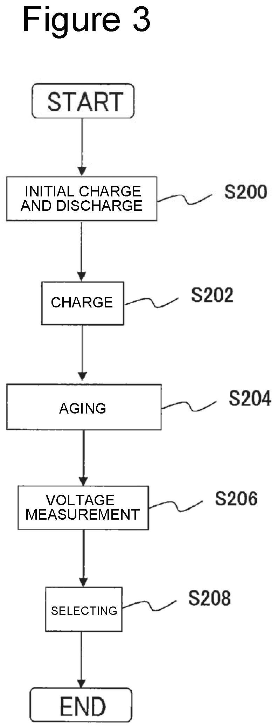

FIG. 3 is a flowchart of a secondary battery testing method as another example of the embodiment. The secondary battery testing method shown in FIG. 3 includes an initial charging and discharging step (step S200), a charging step (step S202), an aging step (S204), a voltage measuring step (step S206), and a selecting step (step S208).

The initial charging and discharging step (step S200) and the charging step (step S202) are similar to the initial charging and discharging step (step S100) and the charging step (step S102) described above.

### (Voltage Measuring Step)

In the voltage measuring step (step S206), the voltage V of the lithium ion secondary battery after the aging step (step S204) is measured. An aging temperature in the aging step (step S204) is not particularly limited, but is, for example, preferably in the range of 15°C to 60°C, and more preferably in the range of 20°C to 40°C, from the viewpoint of stabilizing battery characteristics and the like.

### (Selecting Step)

In the selecting step (step S208), the lithium ion secondary battery is selected based on the voltage V measured in the voltage measuring step (step S206). For example, VA±3σ obtained by calculating VA which is an average value of the voltages V of the respective lithium ion secondary batteries and the standard deviation σ are used as the selection criteria. When the voltage V of the lithium ion secondary battery falls within the range of VA±3σ, the lithium ion secondary battery is determined as a non-defective product, and when the voltage V of the lithium ion secondary battery falls outside the range of VA±3σ, the lithium ion secondary battery is determined as a defective product.

According to the secondary battery testing method shown in FIG. 3, the voltage measurement is performed only once after the aging step (step S204), and thus it is possible to determine the quality of the lithium ion secondary battery in a shorter time as compared with the secondary battery testing method shown in FIG. 1. However, from the viewpoint of improving the accuracy of the quality determination of the lithium ion secondary battery, it is preferable to select the lithium ion secondary battery based on the voltage difference ΔV before and after aging of the lithium ion secondary battery as in the secondary battery testing method shown in FIG. 1.

The lithium ion secondary battery is obtained, for example, by housing an electrode assembly in which a positive electrode and a negative electrode are wound or laminated with a separator interposed therebetween in a housing such as a battery can or a laminate together with an electrolyte. Known materials can be used for the positive electrode, the negative electrode, the separator, and the electrolyte, and are, for example, as follows.

### <Positive Electrode>

The positive electrode includes a positive electrode current collector such as a metal foil and a positive electrode mixture layer formed on the positive electrode current collector. As the positive electrode current collector, a foil of a metal that is stable in a potential range of the positive electrode, such as aluminum, a film in which the metal is disposed on a surface layer thereof, or the like can be used. The positive electrode mixture layer includes, for example, a positive electrode active material, a conductive agent, and a binder.

Examples of the positive electrode active material include lithium transition metal composite oxides, and specifically, lithium cobaltate, lithium manganate, lithium nickelate, lithium nickel manganese composite oxide, and lithium nickel cobalt composite oxide and the like can be used, and Al, Ti, Zr, Nb, B, W, Mg, and Mo and the like may be added to these lithium transition metal composite oxides.

Examples of the conductive agent include carbon powders such as carbon black, acetylene black, Ketjenblack, and graphite.

Examples of the binder include a fluorine-based polymer and a rubber-based polymer. Examples of the fluorine-based polymer include polytetrafluoroethylene (PTFE), polyvinylidene fluoride (PVdF), and modified products thereof, and examples of the rubber-based polymer include an ethylene-propylene-isoprene copolymer, an ethylene-propylene-butadiene copolymer, a styrene-butadiene copolymer, and carboxymethyl cellulose.

### <Negative Electrode>

The negative electrode includes, for example, a negative electrode current collector such as a metal foil and a negative electrode mixture layer formed on the negative electrode current collector. As the negative electrode current collector, a foil of a metal stable in a potential range of the negative electrode, such as copper, a film in which the metal is disposed on a surface layer, or the like can be used. The negative electrode mixture layer contains, for example, a negative electrode active material and a binder.

As the negative electrode active material, a carbon material capable of occluding and releasing lithium ions can be used, and in addition to graphite, non-graphitizable carbon, graphitizable carbon, fibrous carbon, coke, and carbon black and the like can be used. Furthermore, as a non-carbon-based material, silicon, tin, and alloys or oxides mainly containing these can be used. The binder may be the same as in the case of the positive electrode.

### <Electrolyte>

The electrolyte has, for example, ion conductivity (for example, lithium ion conductivity). The electrolyte may be a liquid electrolyte (an electrolytic solution) or a solid electrolyte.

The liquid electrolyte (the electrolytic solution) contains, for example, a non-aqueous solvent and an electrolyte salt dissolved in the non-aqueous solvent. Examples of the non-aqueous solvent include esters, ethers, nitriles, amides, and mixed solvents of two or more thereof. Examples of the non-aqueous solvent include ethylene carbonate (EC), ethyl methyl carbonate (EMC), dimethyl carbonate (DMC), diethyl carbonate (DEC), and mixed solvents thereof. The non-aqueous solvent may contain a halogen-substituted product (for example, fluoroethylene carbonate or the like) in which at least a part of hydrogen in these solvents is substituted with a halogen atom such as fluorine. As the electrolyte salt, for example, a lithium salt such as LiPF₆ is used.

As the solid electrolyte, for example, a solid or gel polymer electrolyte, an inorganic solid electrolyte, or the like can be used. For example, the polymer electrolyte contains a lithium salt and a matrix polymer or contains a non-aqueous solvent, a lithium salt, and a matrix polymer. As the matrix polymer, for example, a polymer material that absorbs a non-aqueous solvent and gelates is used. Examples of the polymer material include a fluororesin, an acrylic resin, and a polyether resin. Examples of the inorganic solid electrolyte that can be used include materials known in the technical field of, e.g., all-solid-state lithium ion secondary batteries (for example, oxide-based solid electrolytes, sulfide-based solid electrolytes, and halogen-based solid electrolytes). Note that the electrolytes described above as examples are non-aqueous electrolytes but the electrolyte is not limited to a non-aqueous electrolyte, and may be an aqueous electrolyte.

### <Separator>

As the separator, a porous sheet or the like having an ion permeation property and an insulation property is used. Specific examples of the porous sheet include microporous thin films, woven fabrics, and nonwoven fabrics. As the material of the separator, an olefin-based resin such as polyethylene or polypropylene, cellulose, or the like is suitable.

### EXAMPLES

Hereinafter, the present disclosure will be further described with reference to Examples and Comparative Examples, but the present disclosure is not limited to the following Examples.

### <Example 1>

Five defective lithium ion secondary batteries in which a minute internal short circuit occurred and 95 non-defective lithium ion secondary batteries in which a minute internal short circuit did not occur were combined to prepare 100 lithium ion secondary batteries.

Under a temperature environment of 25°C, the 100 lithium ion secondary batteries were constant-current (0.5 C, 4.2 V cut)/constant-voltage (4.2 V, 0.02 C cut) charged, and then discharged at a constant current of 0.2 C until the battery voltage reached 2.75 V (initial charge and discharge step).

Next, the lithium ion secondary battery after the initial charge and discharge step was constant-voltage charged at a constant voltage of a battery voltage of 3.25 V under a temperature environment of 25°C until the state of charge of the lithium ion secondary battery reached 3% (charging step). An SOC-OCV curve was previously measured using a non-defective lithium ion secondary battery, and it was confirmed that the gradient of the tangent of the SOC-OCV curve in the state of charge of 3% was greater than 0.02.

Next, the voltage V1 of each lithium ion secondary battery after the charging step was measured (first voltage measuring step). The lithium ion secondary batteries after the first voltage measuring step were put into the aging step, and the voltage V2 of each of the lithium ion secondary batteries was measured (second voltage measuring step).

In each of the lithium ion secondary batteries, a voltage difference ΔV between the voltage V1 and the voltage V2 was obtained together with the measurement of the voltage V2, the average value ΔVA and the standard deviation σ thereof were calculated, and the lithium ion secondary batteries were selected according to a selection criteria (ΔVA±3σ) (selecting step). The steps from the aging step to the selecting step were repeated until the voltage differences ΔV of all the five defective lithium ion secondary batteries were out of the range of the selection criterion (ΔVA±3σ), and an aging period required to completely eject the defective products was measured. As a result, all the defective products were ejected after two days from the start of aging. From this, it can be determined that the aging period required to eject all the defective products by the testing method of Example 1 is at least two days.

### <Example 2>

A lithium ion secondary battery was tested under the same conditions as in Example 1 except that in the charging step, the lithium ion secondary battery after the initial charging and discharging step was constant-voltage charged at a constant voltage of a battery voltage of 3.15 V until the current value reached 0.01 C and then constant-current charged at a constant current of 1 C until the state of charge of the lithium ion secondary battery reached 3% under a temperature environment of 25°C. As a result, after two days from the start of aging, the voltage differences ΔV of all the five defective lithium ion secondary batteries fell outside the range of the selection criterion (ΔVA±3σ). From this, it can be determined that the aging period required to eject all the defective products by the testing method of Example 2 is at least two days.

### <Comparative Example 1>

A lithium ion secondary battery was tested under the same conditions as in Example 1 except that in the charging step, the lithium ion secondary battery after the initial charging and discharging step was constant-current charged at a constant current of 1 C until the state of charge of the lithium ion secondary battery reached 30% under a temperature environment of 25°C. It is confirmed that the gradient of the tangent of an SOC-OCV curve in the state of charge of 30% is smaller than 0.02.

In Comparative Example 1, the voltage differences ΔV of all the five defective lithium ion secondary batteries fell outside the range of the selection criterion (ΔVA±3σ) after six days from the start of aging. From this, it can be determined that the aging period required to eject all the defective lithium ion secondary batteries by the testing method of Comparative Example 1 is at least six days.

### <Comparative Example 2>

A lithium ion secondary battery was tested under the same conditions as in Example 1 except that in the charging step, the lithium ion secondary battery after the initial charging and discharging step was constant-current charged at a constant current of 1 C until the state of charge of the lithium ion secondary battery reached 3% under a temperature environment of 25°C.

In Comparative Example 2, the voltage differences ΔV of all the five defective lithium ion secondary batteries fell outside the range of the selection criterion (ΔVA±3σ) after three days from the start of aging. That is, it can be determined that the aging period required to eject all the defective lithium ion secondary batteries by the testing method of Comparative Example 2 is at least three days.

As described above, by performing the charging step of constant-voltage charging or constant-voltage/constant-current charging the secondary battery to the state of charge set in the state of charge region where the gradient of the tangent of the SOC-OCV curve of the secondary battery is greater than 0.02, the aging period required to eject the defective lithium ion secondary batteries can be shortened. Furthermore, the charging time can be shortened by starting the charging of the secondary battery from constant-voltage charging in the charging step. As described above, the testing period is remarkably shortened by shortening the aging period and the charging time.

## Claims

1. A secondary battery testing method comprising:
a charging step of constant-voltage charging or constant-voltage/constant-current charging a secondary battery to a predetermined state of charge;
an aging step of aging the secondary battery charged in the charging step;
a voltage measuring step of measuring a voltage of the secondary battery after at least the aging step; and
a selecting step of selecting the secondary battery based on the voltage of the secondary battery measured in the voltage measuring step, wherein
the predetermined state of charge is set in a state of charge region where a gradient of a tangent of an SOC-OCV curve indicating a relationship between a state of charge (SOC) of the secondary battery and an open circuit voltage (OCV) is greater than 0.02.

2. The secondary battery testing method according to claim 1, wherein
the voltage measuring step includes a first voltage measuring step of measuring a voltage V1 of the secondary battery before the aging step and a second voltage measuring step of measuring a voltage V2 of the secondary battery after the aging step, and
in the selecting step, the secondary battery is selected based on a voltage difference ΔV between the voltage V1 and the voltage V2.

3. The secondary battery testing method according to claim 1 or 2, further comprising an initial charging and discharging step of charging and discharging the secondary battery before the charging step.
